# EUROPEAN PATENT APPLICATION

(11) **EP 3 079 169 A1**
(43) Date of publication of application: **12.10.2016**
(21) Application number: 14868131.5
(22) Date of filing: 27.11.2014
(51) Int. Cl.: H01L 23/28, H01L 23/14, H01L 23/50, H05K 1/02, H05K 3/00

(54) **MOUNTING UNIT**

(30) Priority: 06.12.2013 JP 2013253103
(71) Applicant: Kabushiki Kaisha Tokai-Rika-Denki-Seisakusho, Niwa-gun, Aichi 480-0195 (JP)
(72) Inventor: ITO, HAJIME, Niwa-gun Aichi 480-0195 (JP)
(74) Representative: TBK
(86) International application number: PCT/JP2014/081300
(87) International publication number: WO 2015/083596

(57) **Abstract**

Amounting unit (3) is provided with the following: a molded resin part (4); a lead frame (5) that is supported by the molded resin part (4) and that includes a plurality of frame pieces (15, 16), where each of the plurality of frame pieces (15, 16) includes lands (17, 18); and an electronic component (6) that is electrically connected to the lands (17, 18) of the plurality of frame pieces (15, 16). The molded resin part (4) has one side (20) that intersects the plurality of frame pieces (15, 16). The plurality of frame pieces (15, 16) are disposed in parallel.

## Description

### TECHNICAL FIELD

The present invention relates to a mounting unit in which an electronic component is mounted on a lead frame supported by a molded resin portion.

### BACKGROUND ART

A known bonding structure reduces mechanical stress that may be generated at portions where an electronic component is bonded to two lead frames when mounting the electronic component on the two lead frames (refer to, for example, patent document 1). It is known that, for example, expansion and contraction of a molded resin portion that supports the lead frames applies mechanical stress to solder portions that bond the lead frames and the electronic component. In patent document 1, predetermined portions of the lead frames are reduced in thickness to reduce the mechanical stress applied to the solder portions. This limits breakage (cracking) of the solder portion.

### PRIOR ART DOCUMENT

### PATENT DOCUMENT

Patent Document 1: Japanese Laid-Open Patent Publication No. 2007-234737

### SUMMARY OF THE INVENTION

### PROBLEMS THAT ARE TO BE SOLVED BY THE INVENTION

The direction of expansion and contraction causing mechanical stress changes depending on, for example, the length of the lead frames or the layout pattern of the lead frames. More specifically, the mechanical stress applied to the solder portion varies in accordance with the shape and the layout pattern of the lead frames. Thus, when the predetermined portions of the lead frames are just reduced in thickness, mechanical stress cannot be sufficiently reduced and cracking of the solder portions cannot be sufficiently limited just by reducing the thickness of the predetermined portions.

It is an object of the present invention to provide a mounting unit that limits cracking of bonding portions that bond an electronic component to a lead frame.

### MEANS FOR SOLVING THE PROBLEM

One aspect of the present invention is a mounting unit that includes a molded resin portion, a lead frame supported by the molded resin portion, and an electronic component. The lead frame includes a plurality of frame pieces. Each of the frame pieces includes a land. The electronic component is electrically connected to the lands of the frame pieces. The molded resin portion has a side that intersects with the frame pieces. The frame pieces are arranged beside each other.

Preferably, in the above structure, the frame pieces are arranged parallel to each other.

Preferably, in the above structure, the molded resin portion includes a hollow portion so that the lands do not contact the molded resin portion.

Preferably, in the above structure, each of the frame pieces includes a base embedded in the molded resin portion, and each of the frame pieces includes an extension that extends from the base so that the frame pieces extend toward each other but are separated from each other.

Preferably, in the above structure, the molded resin portion includes a support that supports bases of the frame pieces. The support includes a first portion, located between the bases of the frame pieces and an upper surface, and a second portion, located between the bases of the frame pieces and a lower surface. The first portion and the second portion have the same thickness.

Preferably, in the above structure, the molded resin portion includes a support that supports bases of the frame pieces, and the molded resin portion includes a through hole arranged adjacent to the support.

Preferably, in the above structure, the molded resin portion includes a hollow portion that exposes the lands of the frame pieces. Each of the frame pieces includes a straight portion that extends parallel to the other frame piece from at least one of inner wall surfaces of the molded resin portion in the hollow portion.

Preferably, in the above structure, each of the frame pieces includes a bent portion, formed integrally with the straight portion, and a distal portion, formed integrally with the bent portion. The distal portion includes the land. The distal portions of the frame pieces are opposed to each other.

Preferably, in the above structure, the molded resin portion includes a support formed in the at least one of inner wall surfaces of the molded resin portion and supports a portion of the frame pieces. The support is thinner than the molded resin portion.

### EFFECT OF THE INVENTION

The present invention limits cracking of a bonding portion that bonds an electronic component to a lead frame.

### BRIEF DESCRIPTION OF THE DRAWINGS

Fig. 1 is a perspective view showing an apparatus to which a mounting unit is coupled.
Fig. 2 is a perspective view showing the mounting unit as viewed in another direction.
Fig. 3 is a plan view showing the mounting unit.
Fig. 4 is a cross-sectional view taken along lines II-II in Fig. 3.
Fig. 5 is a perspective view showing the mounting unit as viewed from a lower surface.
Fig. 6 is a schematic view showing the mounting unit including two frame pieces opposed to each other.
Fig. 7 is a schematic view showing the mounting unit including two frame pieces angled at 90 degrees from each other.
Fig. 8 is a schematic view showing the mounting unit including two frame pieces extending parallel from the same side.

### EMBODIMENTS OF THE INVENTION

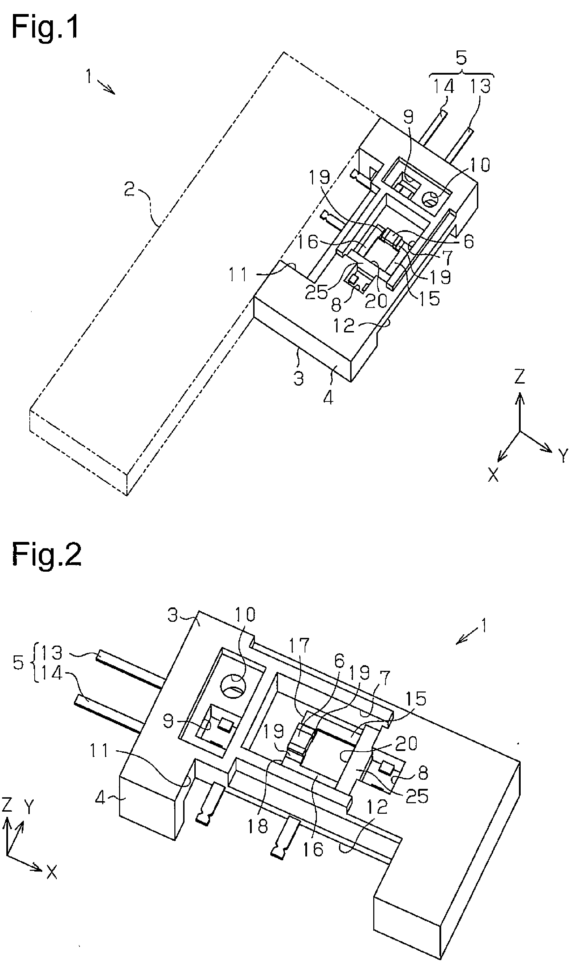

One embodiment of a mounting unit will now be described with reference to Figs. 1 to 8.

As shown in Fig. 1, an apparatus 1, which may be, for example, an antenna apparatus, includes a main body 2, which is a main portion of the apparatus 1, and a mounting unit 3, which is coupled to the main body 2. Preferably, the main body 2 includes an antenna component in which, for example, an antenna cable is wound around a bobbin a number of times. The mounting unit 3 includes a molded resin portion 4, a lead frame 5 supported by the molded resin 4, and an electronic component 6 mounted on the lead frame 5. In the mounting unit 3, for example, the lead frame 5 is electrically connected to the antenna cable of the main body 2. The molded resin portion 4 and the lead frame 5 are formed integrally with each other, for example, through resin molding.

As shown in Fig. 2, a hollow portion 7 extends through a central portion of the molded resin portion 4 and functions as a space accommodating the electronic component 6 (accommodation space). Preferably, the hollow portion 7 is a hole extending through the molded resin portion 4 in the thickness-wise direction (Z-axis direction in Fig. 2). Preferably, a through hole 8, which extends through the molded resin portion 4 in the thickness-wise direction, is located adjacent to the hollow portion 7. The through hole 8 is used when cutting the lead frame 5. The through hole 8 also functions to limit expansion and contraction that may be generated in the molded resin portion 4 in a width-wise direction (Y-axis direction in Fig. 2).

Preferably, the molded resin portion 4 includes a cutaway portion 9 that is used when cutting the lead frame 5. The cutaway portion 9 and the through hole 8 are located at opposite sides of the hollow portion 7. The cutaway portion 9 is located adjacent to a cutaway portion 10. The cutaway portion 10 is, for example, a circular positioning hole that is used when coupling the mounting unit 3 to the main body 2. One side of the molded resin portion 4 is cut away to define a recess 11. The molded resin portion 4 includes a lower portion that is cut away to define a recess 12.

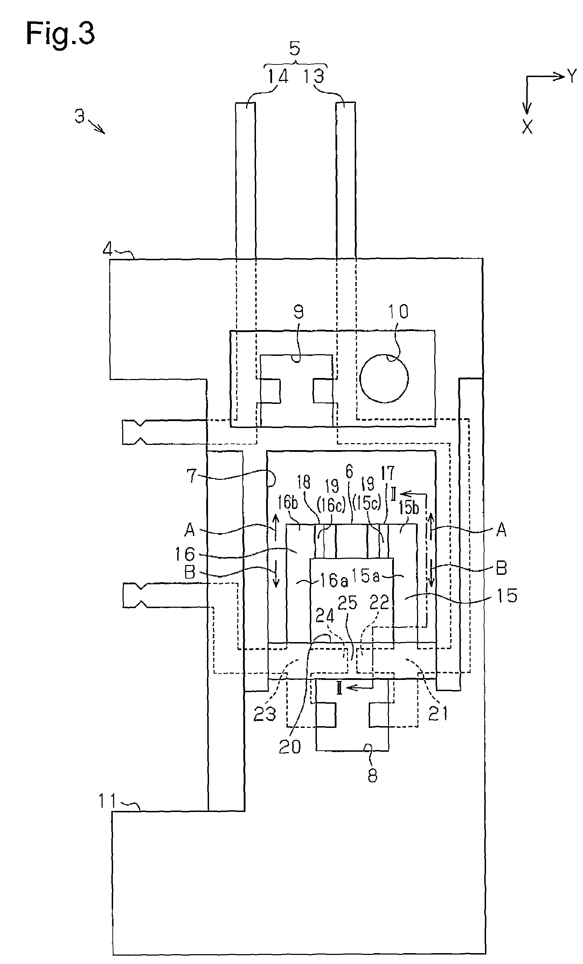

As shown in Fig. 3, preferably, the lead frame 5 includes a first lead frame 13 that forms one line of the lead frame 5 and a second lead frame 14 that forms the other line of the lead frame 5. The electronic component 6 is mounted on a plurality (two in this example) of frame pieces 15, 16 that project from the first lead frame 13. Preferably, the frame pieces 15, 16 are arranged in the hollow portion 7 to extend from a wall surface of the molded resin portion 4. The frame pieces 15, 16 include distal portions including lands 17, 18, respectively. The electronic component 6 is mounted on the two lands 17, 18 to bridge the lands 17, 18. The electronic component 6 is mounted on the lands 17, 18 with bonding portions 19, which may be, for example, solder. Two bonding portions 19 are provided by mounting the electronic component 6 on the lands 17, 18. More specifically, the molded resin portion 4 includes the hollow portion 7, which exposes the lands 17, 18 of the frame pieces 15, 16. The first frame piece 15 includes a straight portion 15a that extends parallel to the other frame piece from at least one inner wall surface of the molded resin portion 4 in the hollow portion 7, a bent portion 15b that is formed integrally with the straight portion 15a, and a distal portion 15c that is formed integrally with the bent portion 15b and includes the land 17. The second frame piece 16 includes a straight portion 16a that extends parallel to the other frame piece from at least one of the inner wall surfaces of the molded resin portion 4 in the hollow portion 7, a bent portion 16b that is formed integrally with the straight portion 16a, and a distal portion 16c that is formed integrally with the bent portion 16b and includes the land 18. The distal portions 15c, 16c are opposed to each other.

When located on the same side 20 of the molded resin portion 4, the frame pieces 15, 16 are arranged beside each other. More specifically, the molded resin portion 4 includes the side 20 that intersects with the frame pieces 15, 16. The frame pieces 15, 16 are arranged beside each other. The side 20 may be referred to as one of the wall surfaces defining the hollow portion 7. Preferably, the frame pieces 15, 16 are arranged, for example, parallel to each other. The frame pieces 15, 16 are arranged to extend parallel from the same side 20 so that when the molded resin portion 4 expands or contracts, the expansion or contraction force acts on the frame pieces 15, 16 in the same direction (direction of arrow A or B in Fig. 3).

Preferably, the first frame piece 15 includes a base 21 embedded in the molded resin portion 4, and the base 21 includes a first extension 22 extending toward the second frame piece 16. Preferably, the second frame piece 16 includes a base 23 embedded in the molded resin portion 4, and the base 23 includes a second extension 24 extending toward the first frame piece 15. More specifically, the frame pieces 15, 16 respectively include the extensions 22, 24 extending from the bases 21, 23 so that the frame pieces 15, 16 extend toward each other but are separated from each other. The first extension 22 and the second extension 24 reduce the volume of the resin in a support 25 of the molded resin portion 4, which supports the frame pieces 15, 16. This limits warpages of the support 25. The through hole 8 is located, for example, beside the support 25 in the molded resin portion 4.

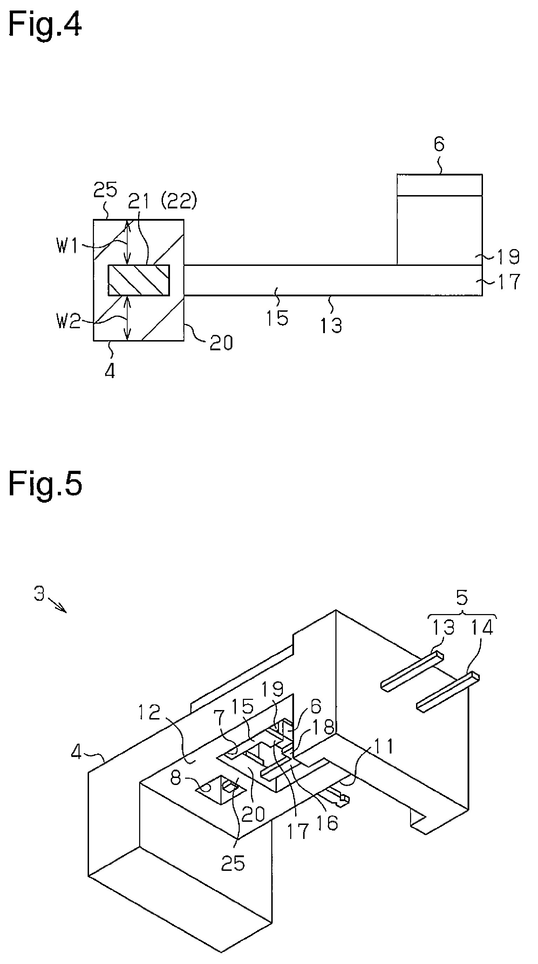

As shown in Figs. 4 and 5, preferably, the molded resin portion 4 includes an upper portion and a lower portion of the support 25, which supports the bases 21, 23 of the frame pieces 15, 16, having the same thickness. More specifically, as shown in Fig. 4, it is preferred that the thickness W1 of the upper portion of the support 25 be the same as the thickness W2 of the lower portion of the support 25. In other words, the support 25 includes a first portion, located between the bases 21, 23 of the frame pieces 15, 16 and the upper surface, and a second portion, located between the bases 21, 23 of the frame pieces 15, 16 and the lower surface. The first portion and the second portion have the same thickness. The thickness relationship is set to reduce the expansion and contraction of the support 25 in the thickness-wise direction of the molded resin portion 4.

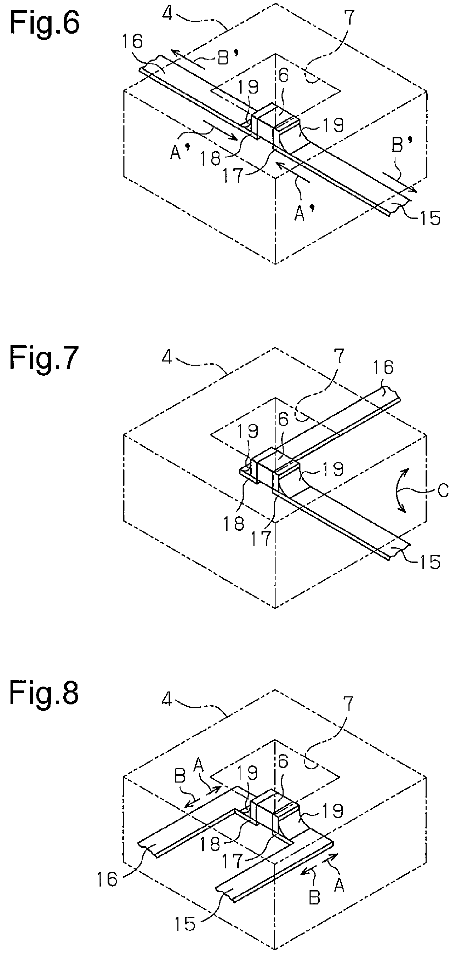

The operation of the mounting unit 3 will now be described with reference to Figs. 6 to 8.

Fig. 6 shows an example of the frame pieces 15, 16 that are opposed to each other in a direction in which the frame pieces 15, 16 extend. In this layout pattern, the molded resin portion 4 may expand (force is generated in direction of arrow A' in Fig. 6) or contract (force is generated in direction of arrow B' in Fig. 6). In each situation of the expansion and the contraction, the bonding portions 19 receive mechanical stress having vectors in opposite directions. Thus, it is assumed that breakage (cracking) easily occurs in the bonding portions 19. More specifically, it is assumed that the large mechanical stress generated in the bonding portions 19 interferes with the bonding of the bonding portions 19.

Fig. 7 shows an example of the frame pieces 15, 16 that are angled at 90 degrees from each other. In this layout pattern, when the molded resin portion 4 expands or contracts, stress in a torsional direction (direction of arrow C in Fig. 7) is generated in the electronic component 6 and the bonding portions 19. Thus, it is assumed that breakage (cracking) easily occurs in the bonding portions 19. More specifically, in the layout pattern including the frame pieces 15, 16 angled at 90 degrees from each other, when the molded resin portion 4 expands and contracts, it is assumed that large mechanical stress generated in the bonding portions 19 interferes with the bonding of the bonding portions 19.

Fig. 8 shows an example of the frame pieces 15, 16 extending parallel to each other from the same side 20. In this layout pattern, when the molded resin portion 4 expands and contracts, the mechanical stress applied to the bonding portions 19 has a vector in the same direction. More specifically, when the molded resin portion 4 expands, the frame pieces 15, 16 each receive force in the direction of the arrow A. When the molded resin portion 4 contracts, the frame pieces 15, 16 each receive force in the direction of the arrow B. Thus, when the molded resin portion 4 expands and contracts, the bonding portions 19 do not receive force having vectors in opposite directions and torsional force. Consequently, the mechanical stress applied to the bonding portions 19 is reduced. This limits cracking of the bonding portions 19 and ensures the reliability in the bonding of the bonding portions 19.

The present embodiment has the advantages described below.
(1) The electronic component 6 is mounted on the two frame pieces 15, 16 that extend from the same side 20 of the molded resin portion 4. This limits situations in which when the molded resin portion 4 expands and contracts, the frame pieces 15, 16 move, for example, in different directions or a torsional direction. Consequently, mechanical stress that induces cracking is inhibited from occurring in the bonding portions 19, which bond the electronic component 6 to the frame pieces 15, 16. This limits situations in which the electronic component 6 is separated from the frame pieces 15, 16.
(2) The two frame pieces 15, 16 are arranged parallel to each other on the same side 20 of the molded resin portion 4. Thus, when the molded resin portion 4 expands and contracts, each of the expansion force and the contraction force is applied to the frame pieces 15, 16 in the same direction (directions of arrow A and arrow B in Figs. 3 and 8). More specifically, when the molded resin portion 4 expands or contracts, mechanical stress is generated in the bonding portions 19 in the same direction. Thus, the mechanical stress does not lead to cracking of the bonding portions 19. This is further advantageous for limiting cracking of the bonding portions 19 when the molded resin portion 4 expands and contracts.
(3) The molded resin portion 4 includes the hollow portion 7, which is free from the resin. Thus, when the molded resin portion 4 expands and contracts, direct application of the expansion and contraction forces to the frame pieces 15, 16 is limited. This further reduces the mechanical stress generated in the bonding portions 19.
(4) The first extension 22 and the second extension 24, which respectively extend from the bases 21, 23 of the frame pieces 15, 16, are arranged proximate to each other. This reduces the resin amount in the support 25 of the molded resin portion 4, which supports the bases 21, 23 of the frame pieces 15, 16. Thus, if the molded resin portion 4 expands and contracts, the expansion and contraction forces applied to the frame pieces 15, 16 are limited. This limits warpage of the support 25 in the molded resin portion 4. Consequently, the mechanical stress generated in the bonding portions 19 is further reduced.
(5) The resin amount in the support 25, which supports the frame pieces 15, 16, is set so that the thickness W1 of the upper portion and the thickness W2 of the lower portion are the same. When the molded resin portion 4 expands and contracts, the expansion and contraction forces are not unevenly generated in one of upper and lower portions of the molded resin portion 4 in the thickness-wise direction. More specifically, the expansion and contraction of the molded resin portion 4 are reduced in the height-wise direction (Z-axis direction in Figs. 1 and 3). This further limits cracking of the bonding portions 19.
(6) The molded resin portion 4 includes the through hole 8 near the bases 21, 23 of the frame pieces 15, 16. Thus, when the molded resin portion 4 expands and contracts, the expansion and contraction of the molded resin portion 4 are limited in the width-wise direction. This further limits cracking of the bonding portions 19 when the molded resin portion 4 expands and contracts.

The embodiment is not limited to the illustrated structures and may be modified as follows.

The bonding portions 19 are not limited to a solder portion and may be changed to another member in correspondence with a bonding process.

Various materials may be used as the molded resin portion 4.

The lead frame 5 may be changed in shape, number, position, layout pattern, and the like.

The electronic component 6 may include various elements such as a capacitor or an IC.

The side of the molded resin portion 4 on which the frame pieces 15, 16 are arranged is not limited to a wall surface defining a hole and may be any wall included in the molded resin portion 4.

The frame pieces 15, 16 are not limited to an accurate parallel arrangement and may be slightly inclined.

A number of sets of the electronic component 6 and the frame pieces 15, 16 may be arranged.

The hollow portion 7 is not limited to a through hole and may be a hole having a closed end.

The through hole 8 may be omitted.

The molded resin portion 4 may be changed to a shape other than that of the embodiment. That is, holes and projections may be located in any position of the molded resin portion 4.

The mounting unit 3 may be applied to various apparatuses and devices.

## Claims

1. A mounting unit comprising:
a molded resin portion;
a lead frame supported by the molded resin portion and including a plurality of frame pieces, wherein each of the frame pieces includes a land; and
an electronic component electrically connected to the lands of the frame pieces, wherein
the molded resin portion has a side that intersects with the frame pieces, and
the frame pieces are arranged beside each other.

2. The mounting unit according to claim 1, wherein the frame pieces are arranged parallel to each other.

3. The mounting unit according to claim 1 or 2, wherein the molded resin portion includes a hollow portion so that the lands do not contact the molded resin portion.

4. The mounting unit according to any one of claims 1 to 3, wherein
each of the frame pieces includes a base embedded in the molded resin portion, and
each of the frame pieces includes an extension that extends from the base so that the frame pieces extend toward each other but are separated from each other.

5. The mounting unit according to any one of claims 1 to 4, wherein
the molded resin portion includes a support that supports bases of the frame pieces,
the support includes a first portion, located between the bases of the frame pieces and an upper surface, and a second portion, located between the bases of the frame pieces and a lower surface, and
the first portion and the second portion have the same thickness.

6. The mounting unit according to any one of claims 1 to 5, wherein
the molded resin portion includes a support that supports bases of the frame pieces, and
the molded resin portion includes a through hole arranged adjacent to the support.

7. The mounting unit according to claim 1, wherein
the molded resin portion includes a hollow portion that exposes the lands of the frame pieces, and
each of the frame pieces includes a straight portion that extends parallel to the other frame piece from at least one of inner wall surfaces of the molded resin portion in the hollow portion.

8. The mounting unit according to claim 7, wherein
each of the frame pieces includes a bent portion, formed integrally with the straight portion, and a distal portion, formed integrally with the bent portion,
the distal portion includes the land, and
the distal portions of the frame pieces are opposed to each other.

## Amended claims

### Amended claims under Art. 19.1 PCT

**1.** (Amended) A mounting unit comprising:
a molded resin portion;
a lead frame supported by the molded resin portion and including a plurality of frame pieces, wherein each of the frame pieces includes a land; and
an electronic component electrically connected to the lands of the frame pieces, wherein the molded resin portion has a side that intersects with the frame pieces,
the frame pieces are arranged beside each other, and
the molded resin portion includes a hollow portion so that the lands do not contact the molded resin portion.

**2.** The mounting unit according to claim 1, wherein the frame pieces are arranged parallel to each other.

**3.** Deleted)

**4.** (Amended) The mounting unit according to claim 1 or 2, wherein
each of the frame pieces includes a base embedded in the molded resin portion, and each of the frame pieces includes an extension that extends from the base so that the frame pieces extend toward each other but are separated from each other.

**5.** (Amended) The mounting unit according to any one of claims 1, 2, and 4, wherein
the molded resin portion includes a support that supports bases of the frame pieces,
the support includes a first portion, located between the bases of the frame pieces and an upper surface, and a second portion, located between the bases of the frame pieces and a lower surface, and
the first portion and the second portion have the same thickness.

**6.** (Amended) The mounting unit according to any one of claims 1, 2, 4, and 5, wherein the molded resin portion includes a support that supports bases of the frame pieces, and the molded resin portion includes a through hole arranged adjacent to the support.

**7.** The mounting unit according to claim 1, wherein
the molded resin portion includes a hollow portion that exposes the lands of the frame pieces, and
each of the frame pieces includes a straight portion that extends parallel to the other frame piece from at least one of inner wall surfaces of the molded resin portion in the hollow portion.

**8.** The mounting unit according to claim 7, wherein
each of the frame pieces includes a bent portion, formed integrally with the straight portion, and a distal portion, formed integrally with the bent portion,
the distal portion includes the land, and
the distal portions of the frame pieces are opposed to each other.
